# FASCICULE DE BREVET EUROPEEN

(11) **EP 0 851 488 B1**
(45) Date de publication et mention de la délivrance du brevet: **12.03.2003**
(21) Numéro de dépôt: 97410150.3
(22) Date de dépôt: 24.12.1997
(51) Int. Cl.: H01L 21/8249, H01L 27/06

(54) **Procédé de formation d'un transistor bipolaire à isolement diélectrique**
Verfahren zur Herstellung eines Bipolartransistors mit dielektrischer Isolation
Process of forming a bipolar transistor with dielectric isolation

(30) Priorité: 27.12.1996 FR 9616337
(43) Date de publication de la demande: 01.07.1998
(73) Titulaire: STMicroelectronics S.A., 92120 Montrouge (FR)
(72) Inventeur: Gris, Yvon, 38210 Tullins (FR); Mourier, Jocelyne, 38120 Saint Egrève (FR); Troillard, Germaine, 38100 Grenoble (FR)
(74) Mandataire: de Beaumont, Michel

(56) Documents cités:
- EP-A- 0 320 217
- EP-A- 0 495 329
- EP-A- 0 746 032
- US-A- 5 471 083
- US-A- 5 547 893

## Description

La présente invention concerne une filière de fabrication de circuits intégrés susceptibles de contenir notamment des composants bipolaires et MOS complémentaires (CMOS). Ce type de filière est habituellement appelé filière BICMOS.

La référence est faite aux documents US-A-5 471 083 et US-A-5 547 893.

Un objet de la présente invention est de prévoir une telle filière dans laquelle les dimensions d'un élément dessiné sur un masque peuvent être inférieures ou égales à 0,4 µm, par exemple 0,2 à 0,35 µm.

Un objet plus particulier de la présente invention est de prévoir une telle filière dans laquelle des composants élémentaires peuvent être isolés les uns des autres par des tranchées remplies de diélectrique.

Pour atteindre ces objets, la présente invention prévoit un procédé de formation de tranchées profondes dans un circuit intégré de type BICMOS dans lequel la formation d'un transistor bipolaire comprend notamment les étapes consistant à déposer une couche de silicium polycristallin de base sur l'ensemble d'une structure semi-conductrice ; déposer une couche d'oxyde de silicium de protection ; former une ouverture d'émetteur-base dans les couches d'oxyde de silicium de protection et de silicium polycristallin de base ; déposer une couche de silicium polycristallin d'émetteur et la graver ; graver la couche d'oxyde de silicium de protection et la couche de silicium polycristallin de base en dehors des zones du transistor bipolaire. Pour la formation des tranchées, ce procédé comprend les étapes consistant à ouvrir l'ensemble des couches d'oxyde de silicium de protection et de silicium polycristallin de base au-dessus d'une zone d'oxyde épais en même temps que l'on réalise l'ouverture d'émetteur-base ; graver la couche d'oxyde épais en même temps que l'on grave la couche d'oxyde de silicium de protection ; et graver le silicium sous l'oxyde épais en même temps que l'on grave le silicium polycristallin de base.

Selon un mode de réalisation de la présente invention, le plus petit des masques de définition de la tranchée est celui qui correspond à l'ouverture de l'ensemble des couches d'oxyde de silicium de protection et de silicium polycristallin de base.

Selon un mode de réalisation de la présente invention, le procédé comprend, préalablement à l'ouverture de l'ensemble des couches d'oxyde de silicium de protection et de silicium polycristallin de base, une étape d'élimination des régions de nitrure de silicium apparentes.

Selon un mode de réalisation de la présente invention, la tranchée a une profondeur de l'ordre de 1 à 1,5 µm.

Selon un mode de réalisation de la présente invention, la tranchée a une largeur de 0,25 à 0,50 µm.

Ces objets, caractéristiques et avantages, ainsi que d'autres de la présente invention seront exposés en détail dans la description suivante de modes de réalisation particuliers faite à titre non-limitatif en relation avec les figures jointes parmi lesquelles :
les figures 1 à 11 sont des vues en coupe schématique illustrant des étapes successives de fabrication d'un mode de réalisation d'un transistor MOS à canal N, d'un transistor MOS à canal P et d'un transistor bipolaire de type NPN ;
la figure 12 est une vue agrandie d'un transistor bipolaire de type NPN obtenu par le procédé illustré en figures 1 à 11 ; et
les figures 13 à 21 représentent des étapes de fabrication d'une tranchée d'isolement selon la présente invention.

Comme cela est usuel dans le domaine de la représentation des composants semiconducteurs, les diverses vues en coupe ne sont pas tracées à l'échelle. Les dimensions latérales et transversales des diverses couches et régions sont arbitrairement dilatées ou rétrécies pour faciliter le tracé des figures.

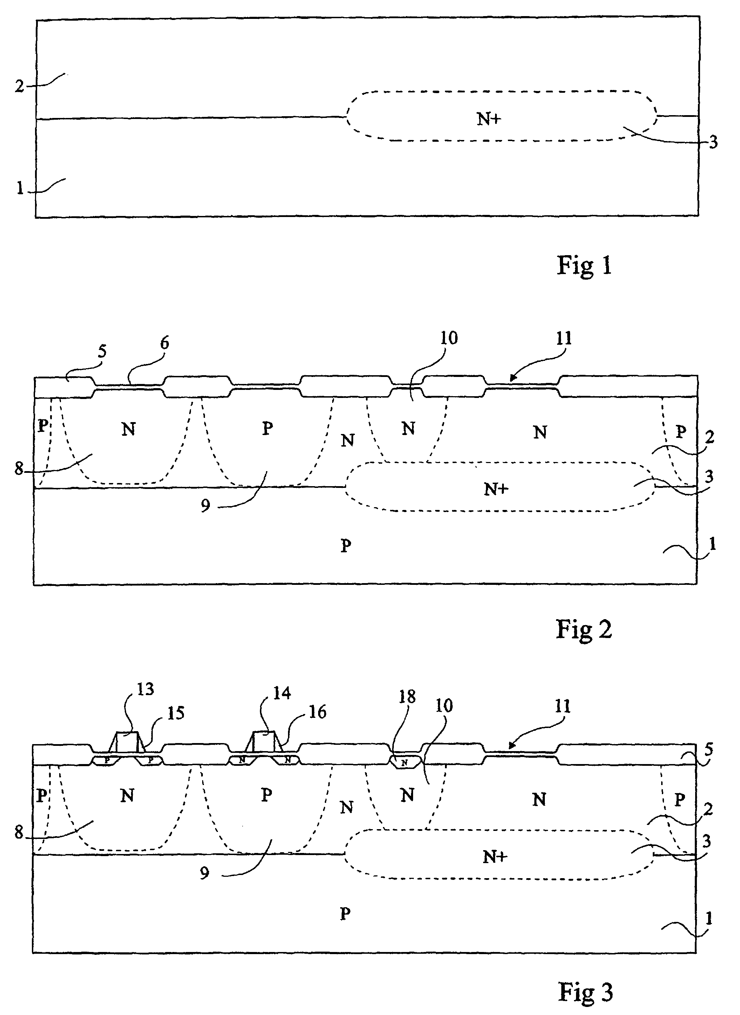

De façon générale dans la suite de la description, on désignera le côté gauche des figures 1 à 11 dans lequel est formé un composant CMOS par l'appellation côté CMOS et le côté droit de ces figures dans lequel est formé un transistor bipolaire de type NPN par l'appellation côté bipolaire. Dans ce qui suit, on décrit la fabrication d'un transistor MOS à canal N, d'un transistor MOS à canal P et d'un transistor bipolaire de type NPN. Bien entendu, dans une réalisation pratique, on formera simultanément de nombreux composants identiques, ainsi qu'éventuellement d'autres types de composants élémentaires.

Selon un aspect de la présente invention, les étapes initiales correspondent à des étapes connues de fabrication de circuits intégrés CMOS de très petites dimensions (dimension minimum, ou dimension de grille, inférieure à 0,35 µm).

Comme le représente la figure 1, on part d'un substrat 1 de type P sur lequel est formée une couche épitaxiale 2 de type N. Cette couche épitaxiale est relativement mince, par exemple d'une épaisseur de l'ordre de 1 à 1,2 µm.

Avant la croissance de la couche épitaxiale, on prévoit si on le souhaite des couches enterrées de types appropriés dans les zones où doivent être formés des caissons N ou P de transistors CMOS et l'on forme une couche enterrée 3 de type N⁺ du côté bipolaire.

Comme le représente la figure 2, du côté CMOS, on délimite les régions des transistors MOS par des ouvertures dans une couche d'oxyde épais 5 formée par toute technique connue. On implante, à travers l'oxyde épais ou une région d'oxyde mince 6 formée dans les ouvertures, des caissons 8 de type N et des caissons 9 de type P, de façon classique. Ces caissons sont par exemple formés par une succession de trois implantations dont l'une traverse l'oxyde épais 5 dans des régions non-masquées. Ces caissons N et P sont destinés respectivement à des transistors MOS à canal P et à des transistors MOS à canal N. Le niveau de dopage en surface (quelques 10¹⁶ at./cm³) détermine la tension de seuil des transistors. Dans le cas général, les caissons P (associés à une couche enterrée P⁺) sont en contact électrique avec le substrat P. On pourra toutefois prévoir de former certains au moins des caissons P sur une couche enterrée de type N. Les caissons N sont complètement isolés puisqu'ils débouchent dans le substrat P et ils sont isolés latéralement par des régions P formées comme les caissons P.

Simultanément, côté bipolaire, on délimite dans l'oxyde épais 5 une région dans laquelle sera formée une diffusion profonde de reprise de contact de collecteur ou puits collecteur 10 rejoignant la couche enterrée 3. Ce puits collecteur est formé par au moins certaines des implantations réalisées pour former le caisson 8 de type N, ou bien par une implantation spécifique de type N⁺. Ce puits collecteur peut aussi être formé ultérieurement en même temps que les sources et drains des transistors MOS à canal N. Egalement, on délimite dans l'oxyde épais une zone 11 dans laquelle seront formés la base et l'émetteur d'un transistor bipolaire de type NPN. Pendant les diverses implantations de caissons N et P, cette zone 11 est masquée.

Comme le représente la figure 3, du côté MOS, on forme de façon classique des grilles isolées 13 et 14 des transistors MOS ; on réalise des premières implantations (LDD) ; on forme des espaceurs 15 et 16 ; et on réalise des implantations de drains et de sources. Dans le caisson 8, les implantations sont de type P et, dans le caisson 9, les implantations sont de type N. En même temps que l'on fait les implantations de sources et de drains des transistors à canal N dans les caissons P, on réalise une diffusion de type N fortement dopée 18 à la surface du puits collecteur 10 pour améliorer la prise de contact ultérieure.

On effectue ensuite un recuit thermique rapide (1025°C).

Après cette étape, à la fin de laquelle l'essentiel des transistors MOS a été réalisé (sauf les éventuelles siliciurations de prise de contact et les métallisations), on procède à la réalisation du transistor bipolaire de type NPN.

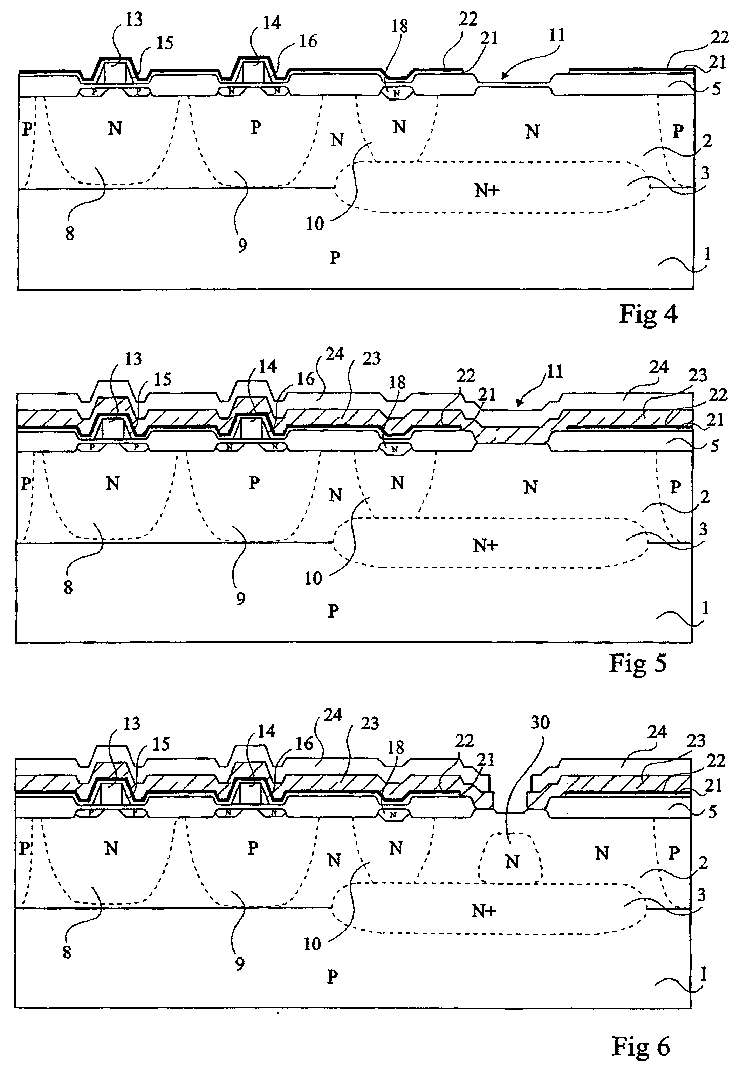

A l'étape illustrée en figure 4, on dépose sur l'ensemble de la structure, par voie chimique en phase vapeur, une double couche de protection comprenant une couche d'oxyde de silicium 21 ayant par exemple une épaisseur de l'ordre de 20 nm suivie d'une couche de nitrure de silicium 22 ayant par exemple une épaisseur de l'ordre de 30 nm. Cette couche 21-22 est ouverte dans la zone 11 où l'on souhaite former la région émetteur-base d'un transistor bipolaire. On notera que cette ouverture n'est pas critique puisqu'elle s'arrête sur des régions d'oxyde épais.

A l'étape illustrée en figure 5, on dépose sur l'ensemble de la structure une couche de silicium 23 ayant par exemple une épaisseur de l'ordre de 200 nm suivie d'une couche d'oxyde d'encapsulation 24 ayant par exemple une épaisseur de l'ordre de 300 nm.

La couche de silicium 23 doit être dopée de type P puisqu'elle servira comme on le verra ci-après de source de dopage pour la base extrinsèque du transistor NPN et sera appelée silicium polycristallin de base. Bien qu'elle soit désignée sous l'appellation silicium polycristallin, il pourra aussi s'agir de tout type de couche de silicium déposé, par exemple du silicium amorphe. De préférence, selon un aspect de la présente invention, on procède d'abord au dépôt d'une couche 23 de silicium polycristallin ou amorphe non dopé et l'on procède ensuite à une implantation d'un dopant de type P dans cette couche. De préférence, on implante du bore sous forme de BF₂ à très forte dose (10¹⁵ à 10¹⁶ at./cm²) et à faible énergie de sorte que le bore implanté se concentre dans la partie supérieure de la couche en évitant toute implantation de bore dans le substrat de silicium sous-jacent dans la région 11.

A l'étape illustrée en figure 6, on procède à une ouverture des couches 24 et 23 dans la partie centrale de la région 11. Cette ouverture a par exemple une largeur comprise entre 0,4 et 0,8 µm et pénètre dans le silicium monocristallin de moins de 50 nm. On procède ensuite à une implantation d'un dopant de type N pour définir le collecteur 30 du transistor NPN. Ce collecteur est donc auto-aligné sur l'ouverture. L'implantation N est réalisée à dose moyenne et forte énergie (par exemple, 10¹² à 10¹⁴ at./cm² sous 500 keV). On obtient ainsi une région effective de collecteur d'étendue latérale limitée, sensiblement égale à celle de la base intrinsèque qui est formée ensuite. Ceci contribue à l'obtention d'un transistor NPN de faible capacité parasite entre collecteur et base extrinsèque. L'implantation est optimisée (par exemple, par implantations successives) pour que le profil du collecteur fournisse le meilleur compromis possible entre, d'une part, la résistance de collecteur et le temps de transit dans ce collecteur et, d'autre part, l'obtention de tensions de claquage suffisamment élevées émetteur-collecteur (typiquement 4 volts) et base-collecteur et d'une faible capacité base-collecteur. On notera aussi que cette implantation de collecteur permet de choisir au préalable une couche épitaxiée 2 de dopage et d'épaisseur propres à optimiser les transistors CMOS et d'optimiser ensuite indépendamment les caractéristiques des transistors NPN. Notamment, cette couche épitaxiée pourra être plus épaisse que si elle devait servir directement de couche de collecteur du transistor NPN.

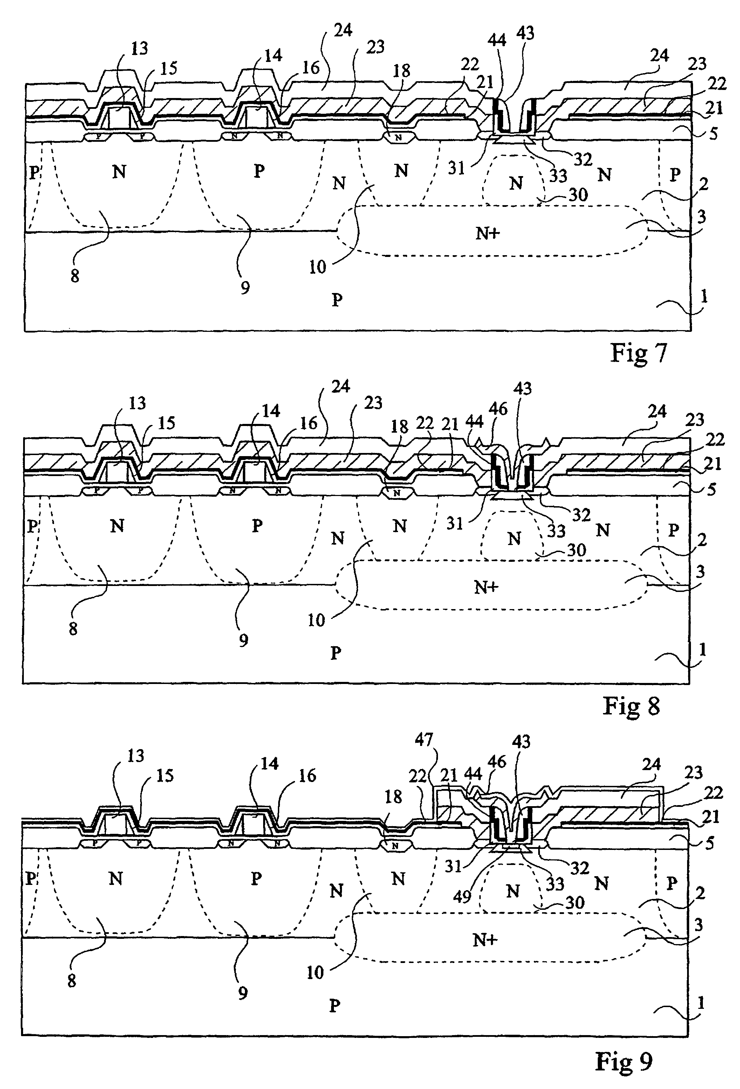

Comme le représente la figure 7, après élimination de la résine de masquage, on procède à une oxydation thermique pendant laquelle il se forme une mince couche d'oxyde thermique 31 d'une épaisseur de l'ordre de 5 à 10 nm et pendant laquelle le bore contenu dans la couche de silicium polycristallin 23 commence à diffuser dans la couche épitaxiée sous-jacente pour former une région de base extrinsèque 32 ayant par exemple une profondeur de jonction de l'ordre de 100 nm. Cette diffusion est ensuite complétée par le recuit final de la structure bipolaire. On procède alors à une implantation de type P à travers l'oxyde 31 pour former une région de base intrinsèque 33 au centre de l'ouverture dans les couches 23 et 24. Cette base intrinsèque est de préférence implantée au bore à faible énergie (par exemple, 10¹³ at./cm² sous 5 keV). Le contact avec le silicium polycristallin 23 résulte de la diffusion latérale du bore du silicium polycristallin.

On procède alors à un dépôt uniforme d'une couche mince de nitrure de silicium (30 nm) revêtue d'une couche de silicium polycristallin (100 nm). La couche de silicium polycristallin est ensuite gravée de façon anisotrope de façon qu'il n'en demeure que des espaceurs 43 sur les flancs de l'ouverture ménagée dans les couches 23 et 24. On procède ensuite à une gravure uniforme du nitrure de silicium, de sorte que ce nitrure de silicium reste en place seulement dans les régions 44 où il est protégé de la gravure (chimique ou plasma) par les espaceurs 43 de silicium polycristallin. L'ensemble du nitrure 44 et des espaceurs 43 définit donc une ouverture plus petite que l'ouverture initialement formée dans les couches 23 et 24 pour la définition de la base intrinsèque. Cette ouverture plus petite est l'ouverture d'émetteur. Si les espaceurs ont une largeur de l'ordre de 150 nm chacun, cette petite ouverture a une largeur de l'ordre de 0,5 µm.

A l'étape illustrée en figure 8, la couche mince d'oxyde 31 au fond de l'ouverture, qui avait servi de protection pendant l'implantation d'émetteur (bore) et d'arrêt de gravure de la couche de nitrure de silicium, est soigneusement nettoyée, par exemple dans un bain d'acide fluorhydrique dilué. On dépose une couche de silicium polycristallin fortement dopé de type N qui est ensuite gravée pour laisser en place une région 46. Des régions de la couche de silicium polycristallin dopé 46 peuvent être maintenues en place en des endroits choisis pour former par exemple des condensateurs entre des régions de ce silicium polycristallin 46 et des régions du silicium polycristallin de base 23.

A l'étape illustrée en figure 9, on élimine les couches d'oxyde 24 et de silicium polycristallin de base 23 en dehors de la région d'émetteur-base du transistor bipolaire et d'autres régions éventuelles comportant des dispositifs utilisant des portions de la couche de silicium polycristallin de base 23 (résistances, capacités...). Puis l'on dépose une couche d'oxyde de silicium d'encapsulation 47.

Après cela, on procède à un recuit de pénétration du dopant contenu dans la couche de silicium polycristallin 46 au centre de la région de base du transistor pour former son émetteur 49 de type N. Les recuits associés au transistor bipolaire assurent une réactivation électrique des dopants et conduisent à des profondeurs de jonction de l'ordre de 60 nm. Les recuits sont du type recuit thermique rapide et/ou au four. Le traitement thermique (30 s, 1000°C) est plus léger que pour les transistors MOS qui ne sont donc pas affectés.

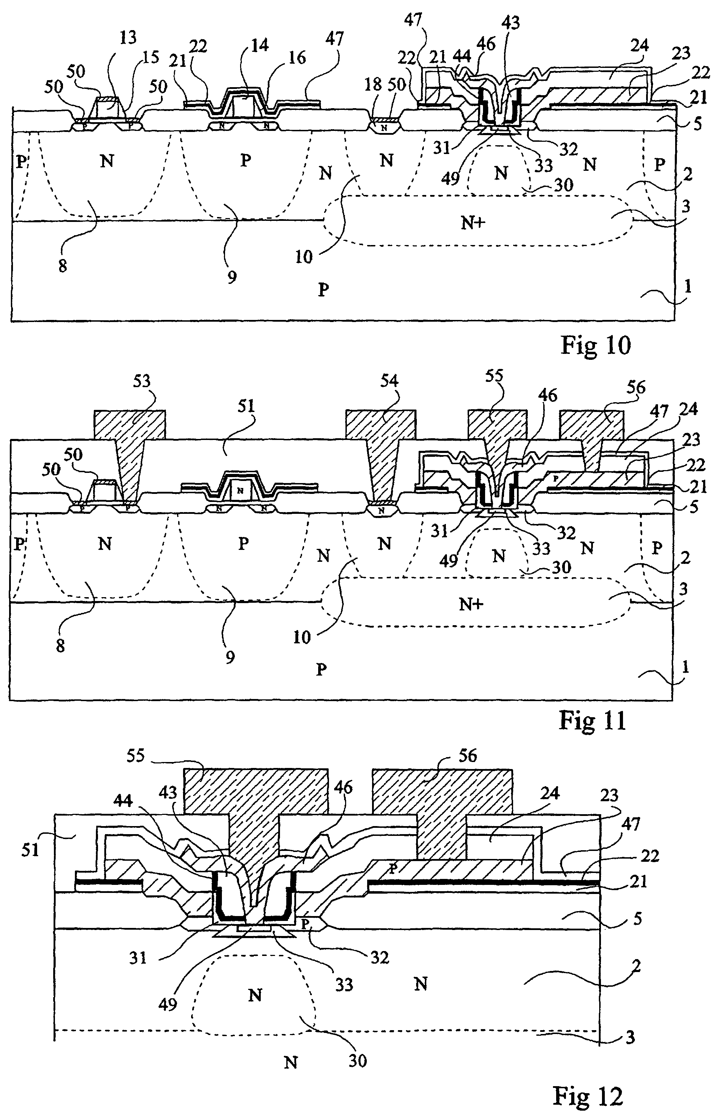

A l'étape illustrée en figure 10, on élimine les couches d'oxyde de silicium d'encapsulation 47, de nitrure de silicium 22 et d'oxyde de silicium de protection 21 au-dessus des zones actives et/ou de silicium polycristallin que l'on souhaite siliciurer, par exemple le transistor MOS à canal P et le puits collecteur du transistor bipolaire. Un siliciure métallique 50 est formé sélectivement au-dessus des régions exposées de silicium mono et polycristallin.

A l'étape illustrée en figure 11, on procède au dépôt d'une couche isolante de planarisation 51 par tout procédé connu, par exemple par dépôt d'une couche de verre dopé au bore et au phosphore (BPSG) et recuit, puis on ouvre cette couche et d'éventuelles couches sous-jacentes aux emplacements où l'on veut prendre des contacts. Seuls certains contacts ont été représentés car, comme cela est bien connu, les contacts ne sont pas nécessairement pris directement au-dessus des zones utiles mais éventuellement sur des prolongements transverses de régions conductrices s'étendant à partir de ces zones utiles. Ainsi, en figure 11, on a seulement représenté un contact de drain 53 d'un transistor MOS à canal P, un contact de collecteur 54, un contact d'émetteur 55 et un contact de base 56 du transistor bipolaire.

La figure 12 correspond au côté bipolaire de la figure 11 et représente la région d'émetteur-base du transistor bipolaire à plus grande échelle.

Dans un mode de réalisation particulier, et pour donner un exemple d'ordres de grandeur, on pourra choisir de réaliser une structure avec les données numériques suivantes (où e désigne une épaisseur, et Cs une concentration superficielle ou une concentration moyenne pour une couche homogène) :

| | |
|---|---|
| substrat 1 | Cs = 10¹⁵ at./cm³, |
| couche épi 2 | Cs = 10¹⁶ at./cm³, e = 0,8 à 1,4 µm, |
| couche enterrée 3 | Cs = 10²⁰ at./cm³, |
| oxyda 5 | e = 0,5 µm, |
| sources et drains N ou P | Cs = 10²⁰ at./cm³, e = 0,15 µm. |

Le procédé de fabrication décrit ci-dessus, tout en étant parfaitement compatible avec les filières existantes de fabrication de transistors CMOS à haute définition, permet de réaliser un transistor bipolaire dont les régions de collecteur, de base intrinsèque et d'émetteur sont auto-alignées.

Ce transistor bipolaire présente de nombreux avantages. Ses performances ne souffrent pas de la présence des transistors CMOS. Il peut en particulier être utilisé aux radiofréquences (fréquence de coupure supérieure à 40 GHz). La très forte transconductance et le faible bruit du transistor bipolaire le rendent apte à des applications analogiques. En particulier, le contact de base (en silicium polycristallin P⁺) permet une forte réduction de la résistance de base d'où un facteur de bruit RF intéressant. Ainsi, le transistor bipolaire peut être utilisé en lieu et place de certains transistors AsGa avec un coût moindre et la possibilité de l'associer sur une même puce à un circuit CMOS très performant.

De façon générale, il est connu que, pour obtenir un isolement optimum des divers composants élémentaires d'un circuit intégré, il est souhaitable d'isoler ces composants par des tranchées remplies de diélectrique traversant toute la couche épitaxiale du circuit intégré. Ceci est particulièrement utile dans les circuits de type BICMOS comprenant d'une part des transistors fonctionnant à très haute fréquence, d'autre part des circuits analogiques susceptibles d'être affectés par des porteurs parasites émis par les transistors haute fréquence. De tels circuits se rencontrent partout où l'on mélange ainsi des fonctions différentes, par exemple dans des systèmes de téléphonie mobile. Néanmoins, en pratique, on renonce généralement à réaliser cet isolement par tranchées car il est extrêmement délicat à mettre en oeuvre et on en arrive à réaliser les composants susceptibles d'être parasités dans des puces séparées.

La présente invention propose un procédé de réalisation d'un isolement par tranchées compatible avec le procédé de fabrication de circuit intégré BICMOS décrit précédemment. En particulier, on va montrer que l'on peut réaliser des tranchées par ce procédé en n'utilisant aucune étape supplémentaire par rapport aux étapes précédemment décrites. De plus le procédé décrit permet de localiser la tranchée de façon très précise par auto-alignement à partir d'un masque décrit précédemment.

Les étapes initiales du procédé sont celles décrites précédemment en relation avec les figures 1 à 3, c'est-à-dire que l'on se place à un stade de fabrication auquel les transistors MOS sont pratiquement achevés.

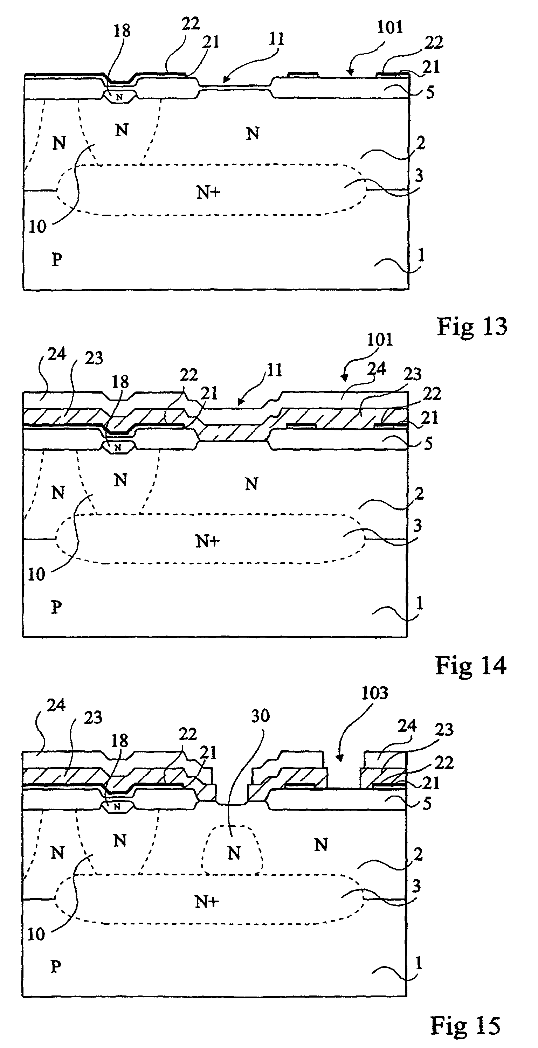

La figure 13 correspond à la figure 4 décrite précédemment. En plus de l'ouverture de la double couche d'oxyde de silicium et de nitrure de silicium 21, 22 aux emplacements d'émetteur-base des transistors bipolaires, on réalise également une ouverture de cette double couche à des emplacements 101 au-dessus d'une région d'oxyde épais 5.

L'étape de la figure 14 correspond à celle de la figure 5, c'est-à-dire que l'on dépose successivement une couche de silicium polycristallin de base 23 d'une épaisseur de par exemple 200 nm et une couche d'oxyde de silicium 24 d'une épaisseur de par exemple 300 nm.

A l'étape illustrée en figure 15, qui correspond à la figure 6, en même temps que l'on ouvre les couches 23, 24 au-dessus des régions d'émetteur-base, on ouvre aussi ces couches au-dessus de l'ouverture 101 de sorte que l'ouverture 103 formée à l'étape de la figure 15 soit plus petite que l'ouverture 101 formée à l'étape de la figure 13. On verra que, au moins dans un mode de réalisation de la présente invention, c'est cette ouverture 103 qui détermine la position et la largeur de la tranchée qui va être formée. Cette position est donc définie avec une grande précision par rapport à celle des autres éléments du circuit intégré. En effet la gravure des couches 23 et 24 était une étape clef du procédé décrit précédemment et le masque correspondant était défini et positionné avec une haute précision.

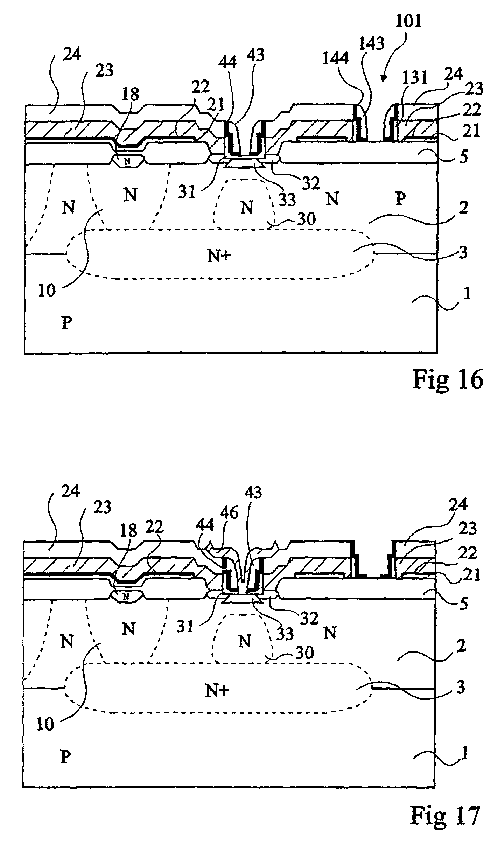

L'étape illustrée en figure 16 correspond à celle illustrée précédemment en figure 7. A cette étape, on forme dans l'ouverture 101, une couche d'oxyde thermique 131 sur les flancs de la couche de silicium polycristallin 23, et des espaceurs en silicium polycristallin 143 enfermant une portion de couche de nitrure 144.

A l'étape de la figure 8, on avait décrit les étapes successives de gravure de l'oxyde thermique 31 au fond de l'ouverture d'émetteur, de dépôt d'une couche de silicium polycristallin d'émetteur 46, et d'élimination par masquage et gravure de cette zone de silicium polycristallin d'émetteur en dehors des zones utiles.

Ces mêmes opérations se répètent dans la zone 103, comme le représente la figure 17. Toutefois, on prolonge de préférence la gravure pour graver entièrement le silicium 46 et en même temps les espaceurs de silicium polycristallin 143 dans cette zone 103.

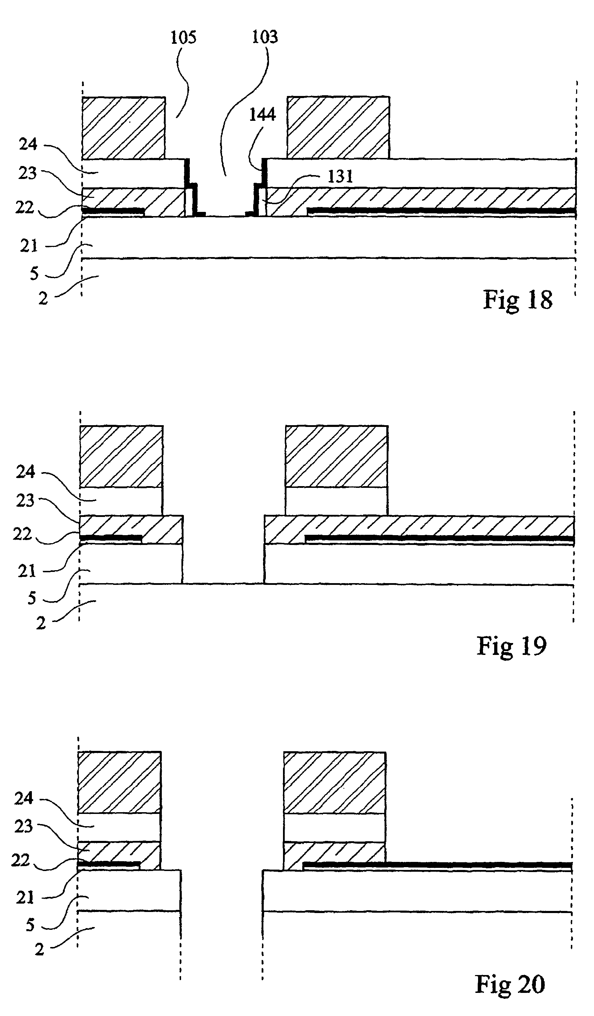

A l'étape décrite en relation avec la figure 9, on avait procédé à la gravure des couches d'oxyde de protection 24 et de silicium polycristallin de base 23 en dehors d'une zone utile. Selon la présente invention, comme l'illustre la figure 18, on ouvre dans une couche de résine servant de masque pour cette opération une ouverture 105 qui correspond à l'ouverture 103.

L'ouverture 105 peut être légèrement plus petite que l'ouverture 103 pour définir la dimension de la tranchée à former.

Toutefois selon un mode de réalisation préféré de la présente invention, illustré en figure 18, l'ouverture 105 déborde par rapport à l'ouverture 103 qui définit la dimension de la tranchée à former.

A une étape dont le résultat est illustré en figure 19, on procède à une gravure plasma isotrope du nitrure de silicium pour éliminer le nitrure 144. Ensuite, en même temps que l'on grave de façon anisotrope la couche d'oxyde de protection 24, on grave, sous l'ouverture 103, la couche d'oxyde épais 5.

A une étape dont le résultat est illustré en figure 20, en même temps que l'on grave la couche de silicium polycristallin 23, on grave la couche épitaxiée 2 formée sur le substrat de silicium, jusqu'à atteindre l'interface entre le substrat de silicium 1 et la couche épitaxiée 2. On réalise ainsi une tranchée profonde d'isolement 150 d'une profondeur de 1 à 1,5 µm et d'une largeur de 0,25 à 0,5 µm ou plus. Les dimensions sont choisies selon le résultat souhaité. Par exemple la tranchée peut s'étendre plus profondément que le fond de la couche enterrée 3.

On notera que les gravures anisotropes susmentionnées de la couche d'oxyde de protection 24 et de la couche de silicium polycristallin 23 peuvent être réalisées sans difficultés particulières. En effet, l'homme de l'art connaît des procédés de gravure sous plasma assurant une bonne sélectivité de gravure entre l'oxyde de silicium et le silicium ou le silicium polycristallin. Il n'y a donc pas de difficultés à prolonger la gravure de la couche d'oxyde 23 pour graver toute l'épaisseur de la couche d'oxyde épais 5. On rappellera que cette couche d'oxyde épais a une épaisseur de l'ordre de 0,5 µm tandis que la couche d'oxyde de protection 23 a une épaisseur de l'ordre de 0,3 µm. De même, quand on grave la couche de silicium polycristallin 23, d'une épaisseur de l'ordre de 0,2 µm, on peut graver sans difficultés simultanément la couche épitaxiée qui a une épaisseur de l'ordre de 1 µm (ou plus), étant donné au surplus que, en dehors de la zone où l'on forme la tranchée, pour la gravure de la couche de silicium polycristallin 23, on a un arrêt de gravure franc sur des régions de nitrure de silicium.

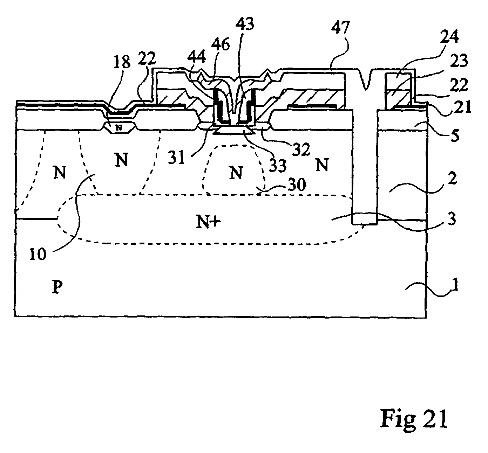

La tranchée profonde 150 ainsi formée pourra être remplie ensuite par de l'oxyde lors du dépôt de la couche d'oxyde de silicium de protection 47 déposée par le processus classique, comme cela est représenté en figure 21.

Après l'étape illustrée en figure 21, le procédé se poursuit par les étapes décrites précédemment en relation avec les figures 10 à 12, sans aucune modification.

On a ainsi formé une tranchée profonde dans la couche épitaxiée du circuit intégré en n'ajoutant aucune étape de fabrication supplémentaire par rapport à celles nécessaires à la formation du circuit intégré décrit précédemment, les seules modifications consistant en une modification des formes des masques et éventuellement en une étape de gravure isotrope de nitrure de silicium.

L'homme de l'art notera que d'autres composants peuvent être imaginés en utilisant la filière selon la présente invention et que celle-ci est susceptible de diverses variantes et modifications. Notamment, les diverses valeurs numériques indiquées l'ont été uniquement à titre d'exemple et chaque matériau indiqué à titre d'exemple pourra être remplacé par un autre matériau ayant la même fonction (par exemple sélectivité de gravure par rapport à d'autres matériaux). De plus, divers composants élémentaires pourront être réalisés avec ou sans couche enterrée de l'un ou l'autre type de conductivité.

## Revendications

1. Procédé de formation de tranchées profondes dans un circuit intégré de type BICMOS dans lequel la formation d'un transistor bipolaire comprend notamment les étapes suivantes :
déposer une couche de silicium polycristallin de base (23) sur l'ensemble d'une structure semi-conductrice ;
déposer une couche d'oxyde de silicium de protection (24) ;
former une ouverture d'émetteur-base dans les couches d'oxyde de (silicium de) protection et de silicium polycristallin de base ;
déposer une couche de silicium polycristallin d'émetteur (46) et la graver ;
graver la couche d'oxyde de silicium de protection (24) et la couche de silicium polycristallin de base (23) en dehors des zones du transistor bipolaire ;
et, pour la formation des tranchées, il comprend les étapes suivantes :
ouvrir l'ensemble des couches d'oxyde de silicium de protection et de silicium polycristallin de base au-dessus d'une zone d'oxyde épais (5) en même temps que l'on réalise l'ouverture d'émetteur-base ;
graver la couche d'oxyde épais (5) en même temps que l'on grave la couche d'oxyde de silicium de protection (24), et
graver le silicium (2) sous l'oxyde épais en même temps que l'on grave le silicium polycristallin de base.

2. Procédé selon la revendication 1, **caractérisé en ce que** le plus petit des masques de définition de la tranchée est celui qui correspond à l'ouverture de l'ensemble des couches d'oxyde de silicium de protection et de silicium polycristallin de base.

3. Procédé selon la revendication 1, **caractérisé en ce que**, préalablement à la gravure de la couche d'oxyde de silicium de protection et à la gravure du silicium polycristallin de base, il comprend une étape d'élimination des régions de nitrure de silicium apparentes (144).

4. Procédé selon la revendication 1, **caractérisé en ce que** ladite tranchée (150) est gravée sur une profondeur de l'ordre de 1 à 1,5 µm.

5. Procédé selon la revendication 4, **caractérisé en ce que** ladite tranchée (150) a une largeur de 0,25 à 0,5 µm.

## Claims

1. A method of forming of deep trenches in a BICMOS-type integrated circuit wherein the formation of a bipolar transistor includes, in particular, the following steps:
depositing a base polysilicon layer (23) on a semiconductive structure;
depositing a protection silicon oxide layer (24);
forming an emitter-base opening in the protection silicon oxide layer and the base polysilicon layer;
depositing an emitter polysilicon layer (46) and etching this layer;
etching the silicon oxide protection layer (24) and the base polysilicon layer (23) outside the areas of the bipolar transistor;
and, for the formation of the trenches, the following steps:
opening the protection silicon oxide and base polysilicon layers altogether above a thick oxide region (5) while the emitter-base opening is being made;
etching the thick oxide layer (5) while the protection silicon oxide layer (24) is being etched; and
etching the silicon (2) under the thick oxide while the base polysilicon is being etched.

2. The method of claim 1, **characterized in that** the smaller of the masks for defining the trench is that which corresponds to the opening of the protection silicon oxide and base polysilicon layers altogether.

3. The method of claim 1, **characterized in that** it includes, prior to the etching of the protection silicon oxide and base polysilicon layers, a step of removal of the apparent silicon nitride layers (144).

4. The method of claim 1, **characterized in that** the trench (150) is etched to a depth of about 1 to 1.5 µm.

5. The method of claim 4, **characterized in that** the trench (150) has a width of 0.25 to 0.50 µm.

## Patentansprüche

1. Verfahren zur Bildung tiefer Gräben in einer gedruckten Schaltung vom BICMOS-Typ, bei welchem die Herstellung eines Bipolar-Transistors die folgenden Schritte umfaßt:
Abscheiden einer polykristallinen Silizium-Basisschicht (23) auf der Gesamtheit einer Halbleiter-Struktur;
Abscheiden einer Siliziumoxyd-Schutzschicht (24);
Bilden einer Emitter-Basis-Öffnung in der Siliziumoxyd-Schutzschicht und der polykristallinen Silizium-Basisschicht;
Abscheiden einer polykristallinen Silizium-Emitterschicht (46) und Formätzen dieser Schicht;
Ätzen der Siliziumoxyd-Schutzschicht (24) und der polykristallinen Silizium-Basisschicht(23)außerhalb der Zonen bzw. Bereiche des Bipolartransistors;
und bei welchem das Verfahren für die Bildung der Gräben die folgenden Schritte bzw. Stufen umfasst:
Öffnen der Gesamtheit der Siliziumoxyd-Schutzschicht und der polykristallinen Silizium- Basisschicht über einer dicken Oxydschicht (5) gleichzeitig mit der Realisierung der Emitter-Basis- Öffnung;
Ätzen der dicken Oxydschicht (5) gleichzeitig mit dem Ätzen der Siliziumoxyd-Schutzschicht (24); sowie
Ätzen des Siliziums (2) unter dem dicken Oxyd gleichzeitig mit dem Ätzen der polykristallinen Silizium-Basis.

2. Verfahren nach Anspruch 1, **dadurch gekennzeichnet, daß** die kleinste der den Graben definierenden Masken diejenige ist, welche dem Öffnen der Gesamtheit der Siliziumoxyd-Schutzschicht und der polykristallinen Silizium-Basisschicht entspricht.

3. Verfahren nach Anspruch 1, **dadurch gekennzeichnet, daß** das Verfahren vor dem Ätzen der Siliziumoxyd-Schutzschicht und dem Ätzen der polykristal-linen Silizium-Basisschicht einen Verfahrensschritt der Beseitigung freiliegender Siliziumnitrid-Bereiche umfaßt.

4. Verfahren nach Anspruch 1, **dadurch gekennzeichnet, daß** der genannte Graben (150) auf eine Tiefe in der Größenordnung von 1 bis 1,5 µm geätzt wird.

5. Verfahren nach Anspruch 4, **dadurch gekennzeichnet, daß** der genannte Graben (150) eine Breite von 0,25 bis 0,5 µm besitzt.
